**Europäisches Patentamt**

**European Patent Office**

**Office européen des brevets**

(19)

(11)  **EP 1 601 110 A1**

(12)  **DEMANDE DE BREVET EUROPEEN**

(43) Date de publication:
**30.11.2005 Bulletin 2005/48**

(51) Int Cl.⁷: **H04B 1/26**, H04B 1/10, H03H 7/01

(21) Numéro de dépôt: **05392003.9**

(22) Date de dépôt: **09.05.2005**

(84) Etats contractants désignés:
**AT BE BG CH CY CZ DE DK EE ES FI FR GB GR HU IE IS IT LI LT LU MC NL PL PT RO SE SI SK TR**
Etats d'extension désignés:
**AL BA HR LV MK YU**

(30) Priorité: **10.05.2004 FR 0405037**

(71) Demandeur: **STMicroelectronics S.A.**
**92120 Montrouge (FR)**

(72) Inventeurs:
• **Cathelin, Andréia**
**38190 Laval (FR)**
• **Belot, Didier**
**38140 Rives (FR)**

(74) Mandataire: **Schuffenecker, Thierry**
**97, chemin de Cassiopée,**
**Domaine de l'étoile**
**06610 La Gaude (FR)**

(54)  **Circuit de réception d'un système de communication hétérodyne intégrable comportant des résonateurs de type BAW**

(57)  Un circuit de réception hétérodyne pour un système de communication numérique comportant un premier filtre passe-bande (22) destiné à recevoir un signal d'une antenne (21), un circuit amplificateur (LNA) et un second filtre à bande étroite (24) destiné à sélectionner un canal particulier au sein d'une bande de fréquence. Les deux filtres sont réalisés au moyen de résonateurs de type BAW intégrables et réglables, respectivement, au moyen d'une première grandeur électrique (consigne1, $V_{tune}$) et d'une seconde grandeur électrique

(consigne2, $V_{tune}$) générées par deux boucles d'asservissement de fréquence de type PLL. La seconde boucle d'asservissement de fréquence de type PLL présente un facteur de division variable afin de permettre la sélection d'un canal particulier au sein de ladite bande de fréquence. Le circuit de réception comporte en outre un mélangeur destiné à mélanger le signal en sortie dudit second filtre (24) et une fréquence d'oscillation locale afin de générer une fréquence intermédiaire. Le facteur de division est commandé par un système de traitement numérique de la fréquence intermédiaire.

Fig. 9

EP 1 601 110 A1

## Description

### Domaine technique de l'invention

La présente invention concerne le domaine des circuits électroniques utilisés en transmission de données, et notamment un circuit de réception d'un système de communication intégrable dans un produit semi-conducteur dotés de résonateurs de type BAW.

### Etat de la technique

L'architecture hétérodyne a été introduite au début du XX ème siècle afin d'améliorer les transmissions sans fil. On rencontre aujourd'hui encore cette architecture dans les récepteurs mobiles les plus récents : téléphones cellulaires, « pagers » , récepteurs fonctionnant à 433 Mhz....

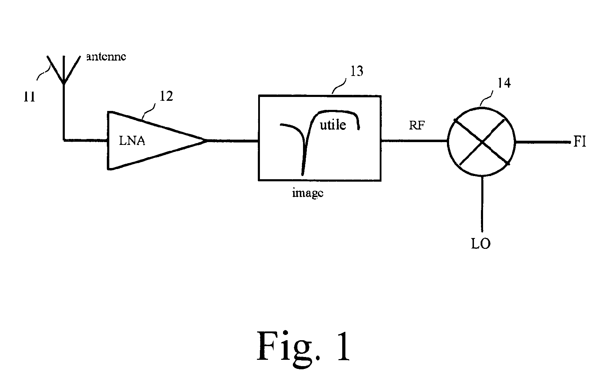

Le principe de l'architecture hétérodyne est rappelé dans la figure 1 qui montre un amplificateur à faible bruit 12 (ou *Low Noise Amplifier* LNA dans la littérature anglo-saxonne) recevant un signal Radio Fréquence (RF) provenant d'une antenne 11 et opérant à une fréquence $f_{RF}$. Un élément de filtrage 13 est intercalé entre l'amplificateur 12 et un mélangeur de fréquences 14. Le mélangeur de fréquence ramène le signal RF à une autre fréquence communément désignée par l'expression Fréquence Intermédiaire $f_{FI}$, en réalisant un mélange avec un signal de référence $f_{OL}$ issu d'un oscillateur local (LO). On peut dès alors effectuer le traitement ultérieur du signal à la fréquence intermédiaire $f_{FI}$ .

En supposant que $f_{OL} < f_{RF}$, l'on peut écrire $f_{RF} = f_{OL} + f_{FI}$. On pourrait conduire un raisonnement similaire pour le cas où $f_{OL} > f_{RF}$.

L'antenne de réception étant un circuit accordé de relativement large bande, d'autres signaux incidents non-désirés seront présents à l'entrée du LNA et notamment la fréquence image : $f_{image} = f_{OL} - f_{FI}$.

D'une manière générale, il faut supprimer cette fréquence image qui pourrait venir perturber la réception du signal RF. En pratique, on rencontre trois méthodes connues pour réaliser cette suppression.

Une première technique est basée sur l'emploi d'un filtre de réjection de la fréquence image, tel que représenté par l'élément 13 de la figure 1. Ce filtre est conçu de manière à présenter un gabarit qui laisse passer tous les signaux, à l'exception toutefois de la fréquence image qui sera fortement atténuée. On attribue couramment à cette première technique l'expression anglo-saxonne «*Notch filter»* et, par extension, une architecture hétérodyne basée sur ce principe de réjection est désigné par l'appellation « architecture de type *Notch* ».

Une seconde technique connue consiste à utiliser, non pas un filtre de réjection, mais un filtre passe bande très étroit dimensionné pour laisser passer uniquement les signaux utiles. Dans cette seconde technique, qui est bien meilleure que la précédente, non seulement la fréquence image est atténuée mais également tous les signaux non utiles. En pratique, cette seconde technique et l'architecture qui en découle - que l'on désigne couramment par l'appellation « architecture à bande étroite » - est difficile à réaliser du fait de la difficulté de mise en oeuvre d'un filtre à bande étroite particulièrement performant. Difficile à réaliser et encore plus à intégrer dans un substrat semi-conducteur.

Pour pallier à la difficulté de mise en oeuvre de la seconde technique, on a alors quelque recours à une troisième technique, ou plutôt une troisième catégorie de techniques qui regroupe divers traitements permettant de s'affranchir du problème de la fréquence image. Par exemple, l'architecture de type homodyne est basée sur une conversion directe de la fréquence RF. On rencontre également dans cette catégories les architectures de type Low-IF - est basée sur un traitement complexe de fréquence, mais également les techniques de type Hartley ou Weaver que l'on regroupe quelquefois sous l'appellation architecture IQ...

D'une manière générale, on se reportera à l'ouvrage suivant pour tout développement relatif aux techniques connues évoquées précédemment :

Aarno Pärssinen, 'Direct Conversion Receivers in Wide-band Systems', Kluwer Academic Publishers, 2001

Si l'on considère à présent le cas de la téléphonie mobile de type *Wide Band Code Division Multiplexing Access,* connue communément sous l'expression W-CDMA, on sait que les bandes utilisées pour cette norme sont :

- en réception, une bande de 60 MHz , allouée de 2110 à 2170 Mhz ;
- en émission , une bande de 60 MHz, de 1920 Mhz à 1980 Mhz.

La bande de fréquence octroyée à un canal est de 5 MHz. Le traitement d'un tel signal, dans une architecture classique de type hétérodyne, impose de pouvoir supprimer les signaux indésirables, et notamment les fréquences images mais également d'autres signaux de forte amplitude opérant à des fréquences bien déterminées que l'on désigne souvent sous l'appellation « bloqueurs ».

Tous ces signaux parasites doivent être supprimés ou fortement atténués avant l'intervention du mélangeur 14.

De manière classique, la plupart des circuits de téléphonie mobile de type WCDMA sont conçus avec un filtre passe-bande sélectif qui est placé à l'entrée du mélangeur, que l'on réalise généralement au moyen de composants acoustiques de type Surface Acoustic Wave (S.A.W.). Ces composants présentent l'inconvénient de ne pas pouvoir être facilement intégrés dans un même produit semi-conducteur.

En aval de ce filtre SAW, on emploie ensuite un circuit de filtrage très sélectif destinée à supprimer la fréquence image avec un fort taux de réjection, en principe au moins 50 dB.

Dans la norme WCDMA , par exemple, la bande d'émission fait 60 MHz et se subdivise en canaux de 5 Mhz, qu'il faut pouvoir isoler distinctivement, ce qui impose des filtres sélectifs dotés de facteurs de qualité de plusieurs centaines d'unités.

- pour la norme W-CDMA : $f_{centre}$ = 2140 MHz, $B_{p\_canal}$ = 5MHz.

$$Q = f_{centre}/\Delta f|_{-3dB} \approx f_{centre}/B_{p\_canal} = 428.$$

- pour la norme GSM : $f_{centre}$ = 943 MHz, $B_{p\_canal}$ = 0.2MHz.

$$Q = f_{centre}/\Delta f|_{-3dB} \approx f_{centre}/B_{p\_canal} = 4715.$$

On constate que les chiffres indiqués ci-dessus rendent pratiquement irréalisable l'utilisation de la seconde technique évoquée précédemment, du fait de la grande difficulté de réalisation de filtres de canaux particulièrement sélectifs aux fréquences radio, et encore moins une complète intégration de cette technique au sein d'un même produit semi-conducteur.

La présente invention a pour but de remédier à ce problème.

**Exposé de l'invention**

C'est un but de la présente invention de permettre la réalisation d'un circuit récepteur basé sur une architecture de type hétérodyne comportant un filtre à bande étroite de grande efficacité permettant la suppression de la fréquence image.

Un autre but de la présente invention consiste à proposer un circuit récepteur d'un système de transmission numérique particulièrement performant et qui permette une intégration complète sur un même substrat de semi-conducteur.

L'invention réalise ces buts au moyen d'un circuit de réception hétérodyne pour un système de communication numérique comportant un premier filtre passe-bande destiné à recevoir un signal d'une antenne et un second filtre à bande étroite destiné à sélectionner un canal particulier au sein d'une bande de fréquence. Les deux filtres sont réalisés au moyen de résonateurs de type BAW intégrables et tous deux réglables, respectivement, au moyen d'une première grandeur électrique (consigne1, $V_{tune}$) et d'une seconde grandeur électrique (consigne2, $V_{tune}$) générées par deux boucles d'asservissement de fréquence de type PLL. La seconde boucle d'asservissement de fréquence de type PLL présente un facteur de division variable afin de permettre la sélection d'un canal particulier au sein de ladite bande de fréquence. Un circuit mélangeur permettant de générer la fréquence intermédiaire vient compléter l'architecture hétérodyne.

Ainsi se trouve assurée la réalisation d'une architecture hétérodyne complètement intégrable sur un substrat de semi-conducteur.

Dans un mode de réalisation préféré, le premier filtre passe bande est réalisé au moyen d'un circuit maître/esclave comportant un circuit esclave destiné à réaliser la fonction de transfert du premier filtre et un circuit maître destiné à être intégré dans la première boucle d'asservissement de fréquence.

Plus spécialement, le circuit esclave du premier filtre comporte au moins un premier résonateur BAW ayant une fréquence de résonance et une fréquence d'antirésonance, le premier résonateur BAW étant associé à un premier élément compagnon de type inductif calé dans un voisinage desdites fréquence de résonance et d'antirésonance et à un second élément compagnon de type capacitif. L'un au moins des deux éléments compagnons étant réglable au moyen de ladite première grandeur électrique (consigne 1, $V_{tune}$),

Le circuit maître esclave du premier filtre comporte au moins un second résonateur BAW disposé sur le même substrat que le précédent et ayant une fréquence de résonance et une fréquence d'antirésonance. Le second résonateur BAW est associé à un premier élément compagnon de type inductif calé dans un voisinage desdites fréquence de résonance et d'antirésonance et à un second élément compagnon de type capacitif. L'un au moins des deux éléments compagnons est réglable au moyen de ladite première grandeur électrique (consigne1, $V_{tune}$) générée par la première boucle d'asservissement de fréquence de type PLL.

La commande des caractéristiques des résonateurs peut être effectuée de diverses manières. De préférence, l'élément capacitif - associé par exemple au premier résonateur BAW - un varactor commandé par ladite première grandeur électrique (consigne1, $V_{tune}$).

De préférence, l'élément inductif est composé d'une inductance spirale disposé sur le substrat de silicium dudit résonateur.

Alternativement, l'élément inductif associé au premier ou au second résonateur est composé d'un gyrateur comportant deux amplificateurs à transconductance et une capacité, ladite première grandeur électrique (consigne1, $V_{tune}$) venant fixer le point de polarisation desdits amplificateurs .

Dans un autre mode de réalisation, l'élément inductif associé à un résonateur est composé d'un gyrateur comportant deux amplificateurs à transconductance et un varactor, ladite première grandeur électrique (consigne1, $V_{tune}$) venant régler la valeur de la capacité dudit varactor.

Dans un mode de réalisation préféré, le second filtre est réalisé au moyen d'un circuit maître/esclave comportant un circuit esclave destiné à réaliser la fonction de transfert bande étroite du second filtre et un circuit maître destiné à être intégré dans la seconde boucle d'asservissement.

Le circuit esclave du second filtre comporte au moins un premier résonateur BAW ayant une fréquence de résonance et une fréquence d'antirésonance et est associé à un premier élément compagnon de type inductif calé dans un voisinage des fréquences dites de résonance et d'antirésonance et à un second élément compagnon de type capacitif. Ledit au moins premier résonateur BAW est réglable au moyen de ladite seconde grandeur électrique (consigne2, $V_{tune}$).

Le circuit maître du second filtre comporte au moins un second résonateur BAW disposé sur le même substrat que le résonateur précédent et ayant une fréquence de résonance et une fréquence d'antirésonance. Ce second résonateur est associé à un premier élément compagnon de type inductif calé dans un voisinage desdites fréquence résonance et d'antirésonance et à un second élément compagnon de type capacitif. L'un au moins des deux éléments compagnons est réglable au moyen de ladite seconde grandeur électrique (consigne2, $V_{tune}$) et intégré dans ladite seconde boucle d'asservissement de fréquence, laquelle comporte un facteur de division réglable permettant de sélectionner un canal désiré.

Comme pour le premier filtre, on pourra venir agir et régler de diverses manière les résonateurs du circuit maître/esclave du second filtre.

On pourra ainsi prévoir, associé au premier ou au second résonateur BAW, un élément capacitif de type varactor commandé par ladite seconde grandeur électrique (Consigne 2, $V_{tune}$).

De préférence, l'élément inductif est - quant à lui - composé d'une inductance spirale disposé sur le substrat de silicium dudit résonateur.

Alternativement, l'élément inductif est composé d'un gyrateur comportant deux amplificateurs à transconductance et une capacité, ladite seconde grandeur électrique (consigne2, $V_{tune}$) venant fixer le point de polarisation desdits amplificateurs. On pourra également prévoir pour l'élément inductif un gyrateur comportant deux amplificateurs à transconductance et un varactor, ladite seconde grandeur électrique (consigne 2, $V_{tune}$) venant régler la valeur de la capacité dudit varactor.

Description des dessins

D'autres caractéristiques, but et avantages de l'invention apparaîtront à la lecture de la description et des dessins ci-après, donnés uniquement à titre d'exemples non limitatifs. Sur les dessins annexés :

La figure 1 illustre le schéma de principe d'un récepteur hétérodyne pour un système de communication numérique.

La figure 2a illustre une courbe d'impédance typique d'un résonateur acoustique de type BAW .

Les figures 2b et 2c rappellent le schéma électrique équivalent du résonateur acoustique de type BAW, respectivement suivant la représentation série et parallèle.

Les figures 3A et 3B illustrent deux modes de réalisation d'un composant résonateur réglable qui est commandé par un signal électrique.

La figure 3c illustre l'intégration d'un composant résonateur réglable dans une architecture Maître-Esclave conforme à la présente invention.

La figure 4a illustre le réglage dudit composant acoustique au moyen d'un varactor.

La figure 4b illustre le réglage dudit composant acoustique réglable au moyen d'une inductance active.

La figure 4c illustre le réglage dudit composant acoustique réglable au moyen d'une inductance active flottante.

La figure 5 illustre une première chaîne d'asservissement - de type PLL - d'un circuit comportant un composant acoustique réglable.

La figure 6 illustre une seconde chaîne d'asservissement - de type ALL - d'un circuit comportant un composant acoustique réglable.

La figure 7 illustre un troisième exemple de chaîne d'asservissement d'un circuit comportant un composant acoustique réglable, basée systématiquement sur une boucle de type PLL et une boucle de type ALL.

Les figures 8A et 8B décrivent respectivement deux modes de réalisation des composants compagnons associés au composant résonateur réglable.

La figure 9 illustre un schéma de principe d'un circuit de réception basée sur une architecture hétérodyne conforme à la présente invention.

La figure 10 illustre le gabarit des filtres réalisés au moyen des résonateurs BAW.

La figure 11 illustre un mode de réalisation particulier des boucles d'asservissement de type PLL utilisables.

**Description d'un mode de réalisation préféré**

On décrira à présent un mode de réalisation d'une architecture de type hétérodyne conforme à la présente invention particulièrement adaptée à la réalisation d'un système de transmission sans fil moderne, et notamment à la norme WCDMA.

Cette architecture hétérodyne est basée sur l'emploi de composants de type BAW et notamment sur un nouveau Composant Résonateur Variable (CRR) (I) facilement intégrable dans une boucle d'asservissement maître/esclave (II) et permettant de multiples variantes et combinaisons d'asservissement (III).

On est en mesure, alors de réaliser une architecture hétérodyne particulièrement performante et, de surcroît, complètement intégrable dans un même circuit intégré (IV).

*1. Composant Résonateur Réglable (CRR) intégrable*

L'invention est basée sur l'emploi d'un nouveau composant acoustique, ci-après désigné par l'expression *Composant Résonateur Réglable* (CRR) - tel que décrit dans la demande de brevet français n° 0315480 (ref 03-GR1-267) déposée le 29 Décembre 2003, et dont on reprendra ci-après - à des fins de clarté - les caractéristiques principales.

A cet effet, on utilise un résonateur acoustique basé sur un milieu diélectrique disposé sur un élément réfléchissant tel un récepteur ou miroir de Bragg par exemple. On réalise un empilement de couches sur un substrat en silicium qui présente des propriétés acoustiques et des constantes diélectriques différentes. Un tel élément acoustique est connu dans la littérature anglosaxonne sous l'appellation *Surface Mounted Resonator* (SMR).

Alternativement, le résonateur pourra être de type *Film Bulk Acoustic Resonator* (FBAR), à savoir disposé au dessus d'une cavité pour permettre la réflexion des ondes acoustiques et éviter leur amortissement.

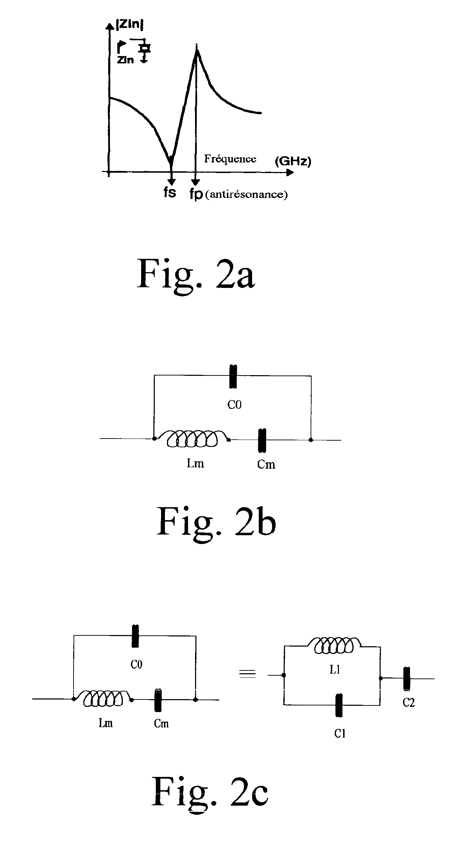

Le résonateur BAW présente deux fréquences de résonance très proches, respectivement fs (série) et fp (parallèle), comme cela est illustré dans la figure 2a. Si l'on se ramène à un schéma électrique équivalent qui est représenté dans la figure 2b, cela revient à considérer deux circuits résonants de type LC, respectivement série et parallèle, composés des éléments Lm, Cm et C0.

Dans l'approche connue, les deux circuits résonants sont employés simultanément à des fins de filtrage comme c'est le cas par exemple dans le document « RF MEMS Circuit Design for Wireless Communications », Hector J ; De Los Santos, Artech House, ISBM 1-58033 329-9, 2002, p. 163 et s.

Au contraire, dans la nouvelle approche qui est proposée, le CRR comporte un résonateur de type BAW qui est associé à au moins deux éléments compagnons et, de préférence, à un premier élément compagnon de type inductif, variable ou non, actif ou passif, et à un second élément compagnon de type capacitif, en général variable.

De façon surprenante, on a constaté qu'il y avait un grand avantage à choisir le premier élément compagnon de type inductif de façon à être calé dans un voisinage des fréquences de résonance et d'anti-résonance. Dans un mode de réalisation particulier, on utilisera une inductance spirale directement intégrée sur le substrat silicium.

Alternativement, le premier élément compagnon est une inductance variable dans le voisinage des fréquences de résonance et d'antirésonance, en fonction d'une grandeur électrique $V_{tune}$.

Le second élément compagnon est de type capacitif et est en général variable, lui également en fonction d'une grandeur électrique, par exemple la grandeur $V_{tune}$.

En venant commander ladite grandeur électrique $V_{tune}$ on peut modifier considérablement les caractéristiques du Composant Résonateur Réglable composé du résonateur acoustique et de ses deux élément compagnons.

D'une manière surprenante, on observe que la combinaison des deux éléments compagnons ainsi choisis permettent de régler dans une large mesure les caractéristiques du CRR, et notamment de tout circuit électronique intégré le comportant, sans trop affecter les performances globales (fréquences de résonance et d'antirésonance, facteur de qualité) de ce même circuit.

On peut alors venir corriger les imprécisions du procédé de fabrication et la dépendance en température et, même, disposer d'un moyen de réglage sur le nouveau composant acoustique.

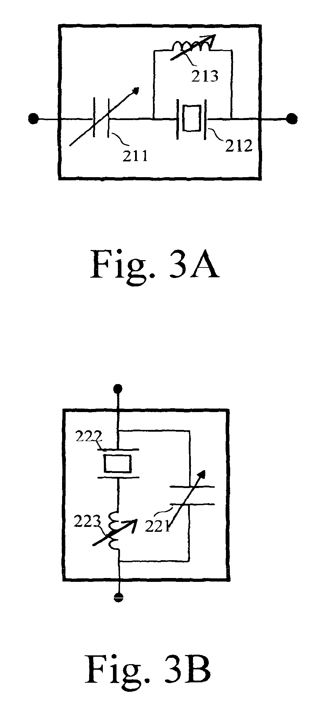

La figure 3A illustre un premier mode de réalisation d'un CRR dans lequel on vient travailler sur la résonance série d'un résonateur BAW 212. On dispose ainsi, en parallèle sur le résonateur 212, une inductance 213 qui est variable de manière à pouvoir être ajustée pour entrer en résonance avec la capacité parallèle de ce même résonateur, proche de la fréquence notée $f_p$, ou dans un voisinage de cette même fréquence.

On peut dès lors travailler convenablement sur la résonance série et commander la fréquence de résonance au moyen d'un élément de réglage capacitif 211.

La figure 3B correspond à un second mode de réalisation d'un CRR dans lequel on vient à présent travailler sur la fréquence parallèle d'un résonateur BAW 222. A cet effet, on dispose cette fois en série avec ce dernier une inductance 223, à nouveau variable de manière à pouvoir être ajustée pour entrer en résonance avec la capacité série équivalente (C2) proche de la fréquence notée fs du résonateur de la figure 1 c, ou dans un voisinage de cette fréquence. On branche ensuite, en parallèle sur les deux éléments en série, un élément de réglage capacitif 221 de manière à venir interagir avec la résonance parallèle du résonateur 222 et la régler la fréquence fp.

On parvient ainsi, grâce à l'action combinée des deux éléments compagnons 221 et 223, à ajuster dans une large gamme la fréquence de travail au moyen de l'élément de réglage, 211 ou 221 selon le cas.

Il y a donc une véritable coopération entre l'inductance 213 (resp. 223) qui, en venant interférer dans un voisinage des deux fréquences de résonance et d'antirésonance du résonateur acoustique, permet de renforcer l'effet de réglage capacitif effectué par 211 (resp. 221).

Il en résulte alors un nouveau composant résonateur réglable, doté d'un résonateur BAW offrant un fort coefficient de qualité, associé à ses deux éléments compagnons.

Une grande flexibilité est ainsi offerte par ce nouveau composant qui est directement intégrable dans une technologie silicium. Il ouvre par conséquent la voie à de multiples nouveaux développement de circuits intégrés dès lors que l'on parvient à commander efficacement son point de fonctionnement au moyen du réglage effectué au niveau des éléments compagnons.

En effet, le circuit que l'on va décrire plus loin, qui permet un asservissement du point de fonctionnement du nouveau composant acoustique, permet non seulement de rattraper les insuffisances du procédé de fabrication, mais vient également fixer avec précision le point de fonctionnement malgré les variations de température.

*II. Intégration du nouveau composant résonateur réglable dans une architecture Maître-Esclave*

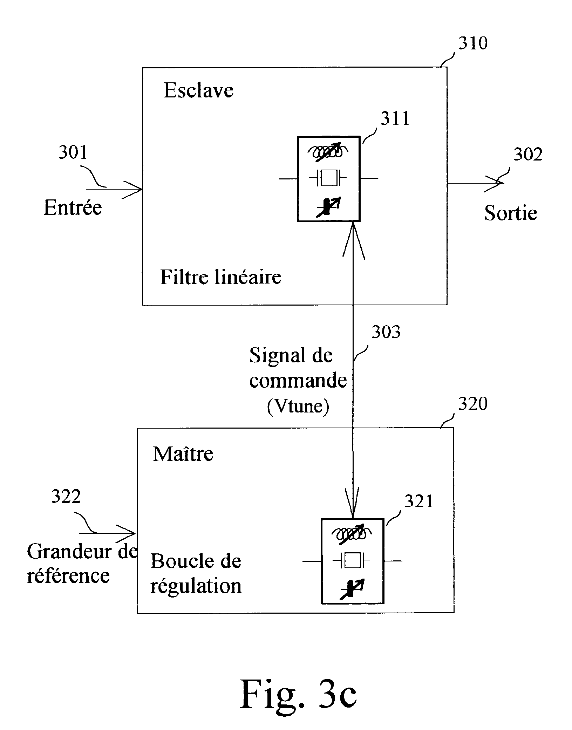

La figure 3c illustre une architecture Maître-Esclave venant intégrer le Composant Résonateur Réglable (CRR) qui permet de venir régler précisément les caractéristiques de fonctionnement de tout circuit incorporant ledit composant CRR.

Comme on le voit dans la figure 3c, on incorpore un CRR 311 dans un circuit ou bloc 310 - dit esclave - permettant de réaliser une fonction électronique intégrée dans un produit semi-conducteur. Le composant CRR 311 comporte, comme précédemment décrit, un résonateur de type BAW doté de ses deux éléments compagnons : un premier élément inductif fixe ou variable, actif ou passif, combiné à un second élément capacitif, en générai variable.

Dans un mode de réalisation préféré, le bloc 310 sert à la réalisation d'un filtrage linéaire intégré tirant avantage du fort coefficient de qualité du résonateur BAW, et doté d'une électrode ou d'une paire d'électrodes d'entrée 301 et d'une électrode ou d'une paire d'électrodes de sortie 302.

Le circuit selon l'invention comporte en outre un second circuit ou bloc 320, dit Maître, linéaire ou non, lequel est doté d'un second CRR 321 qui est homothétique du CRR 311. A cet effet, on s'arrange pour apparier les éléments compagnons des composants 311 et 321 mais aussi les résonateurs BAW eux-mêmes. En particulier, ces derniers seront de même géométrie (ou du moins homothétique), issus du même procédé de fabrication et disposés proches l'un de l'autre sur le même substrat afin d'être soumis aux mêmes conditions de température.

Une grandeur de référence 322 que l'on choisira extrêmement stable commande le second circuit Maître 320. En pratique, on choisira par exemple une fréquence de référence issue d'un oscillateur à quartz ou une tension de référence générée par un bloc du type de celui connu dans la littérature anglo-saxonne par l'appellation « band-gap ».

Chaque composant acoustique réglable dispose d'une électrode de commande recevant via un circuit 303 une grandeur électrique de commande, que l'on désignera pas $V_{tune}$.

Cette grandeur électrique $V_{tune}$, tension ou courant, est transmise à l'un ou plusieurs des éléments compagnons de chaque CRR.

L'homme du métier pourra envisager divers modes de réalisation permettant d'agir sur les éléments compagnons du résonateur BAW.

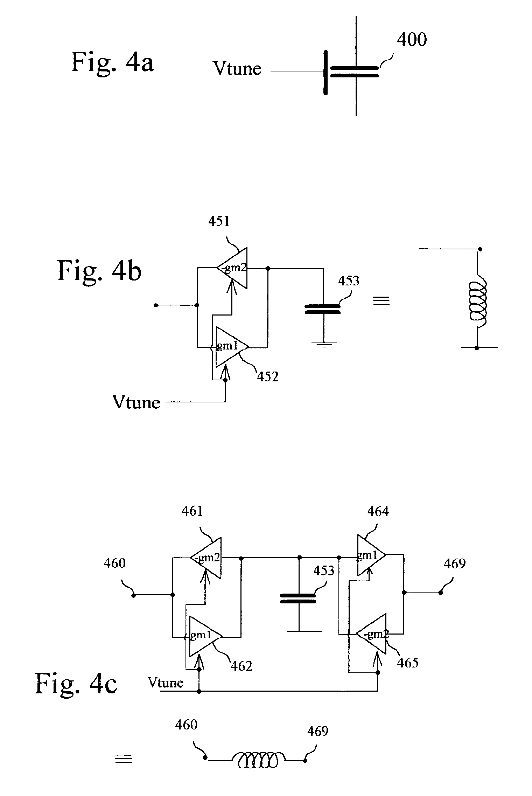

A titre d'exemple nullement limitatif, dans un premier mode de réalisation illustré dans la figure 4a, l'élément compagnon de type capacitif est un varactor recevant la grandeur électrique $V_{tune}$ sur une électrode de commande. On peut ainsi venir régler la valeur de l'élément capacitif associé au résonateur BAW.

La figure 4b illustre un autre mode de réalisation dans lequel l'élément inductif variable est réalisé au moyen d'une inductance active comportant un élément gyrateur composé de deux amplificateurs de transconductances 451 et 452 montés tête-bêche qui est chargé par un élément capacitif 453, le second amplificateur introduisant une inversion de polarité. En venant agir sur cet élément capacitif 453 - qui pourra comme précédemment être un varactor recevant la grandeur électrique de commande $V_{tune}$ - on pourra réaliser un élément inductif variable dont l'une des électrodes est mises à la masse.

Le schéma de la figure 4c illustre la structure d'un élément inductif variable flottant entre deux électrodes 460 et 469. A cet effet, on insère entre l'électrode 460 et la capacité 453 un premier gyrateur formé de deux amplificateurs de transconductance 461 et 462 qui sont montés tête-bêche, le second amplificateur introduisant une inversion de polarité. D'une manière similaire, on insère entre l'électrode 469 et la capacité 453 un second gyrateur formé de deux amplificateurs de transconductance 464 et 465 montés également tête-bêche avec le second amplificateur introduisant une inversion de polarité.

Alternativement, on pourra également venir commander le courant de polarisation des amplificateurs de trans-conductance formant le ou les gyrateurs avec la grandeur électrique $V_{tune}$, afin de venir régler le paramètre gm de ces derniers et, par conséquent, la valeur de l'élément inductif associé au résonateur BAW.

D'autres modes de réalisation permettant le réglage des éléments compagnons associés aux résonateurs contenus dans les composants 311 et 321 pourront être envisagés.

On notera également que dans un souci de clarté on a représenté un unique composant résonateur pour chacun des circuits ou blocs 310 et 320. Il est pourtant clair qu'un homme du métier pourra adapter l'invention à la réalisation d'un bloc 310 (et par suite 320) comportant plusieurs composants résonateurs montés en treillis, en échelle ou de toute autre manière possible.

Suivant l'enseignement de l'invention, on intègre le circuit ou bloc 320 - dit Maître - dans un circuit d'asservissement permettant de commander précisément le point de fonctionnement du composant acoustique réglable 320 via la grandeur électrique de commande $V_{tune}$.

Par recopie de la grandeur sur l'entrée de commande du composant 311 situé dans le bloc esclave 310, on obtient alors un asservissement particulièrement efficace du point de fonctionnement de ce dernier.

La boucle d'asservissement réalisée au sein du bloc Maître 320 permet la commande des caractéristiques du composant dual localisé au sein du bloc Esclave 310, afin d'en permettre le réglage.

En premier lieu on peut corriger les imperfections résultant du procédé de fabrication du produit semi-conducteur et rattraper les défauts dans les tolérances de fabrication. Il en résulte la possibilité d'intégrer le résonateur BAW dans un circuit intégré tout en éviter de jeter au rebus tout le circuit dès lors que le seul composant BAW ne présente pas les caractéristiques souhaitées.

En second lieu, au delà du rattrapage des défauts de tolérance, on réalise ainsi, grâce à l'architecture maître-esclave qui vient d'être décrite, une commande de la caractéristique de résonance du composant résonateur au moyen de la boucle d'asservissement opérée par le bloc 320.

Cette boucle d'asservissement peut permettre une régulation indépendante du procédé de fabrication, mais également de la température.

Afin de montrer la grande flexibilité de l'invention, et les multiples possibilités d'asservissement qui sont ouvertes au concepteur de circuits intégrés, on va décrire à présent plusieurs exemples d'asservissement particulièrement efficaces.

### III. Exemples de boucles d'asservissement

### A. Asservissement de fréquence par intégration du second CRR dans une boucle de type PLL

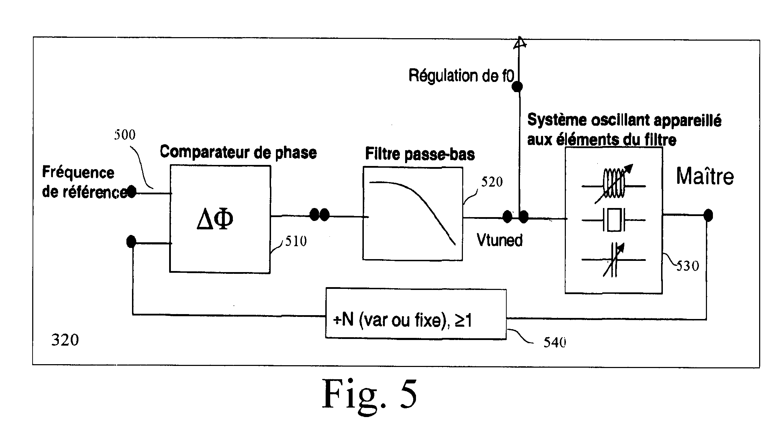

La figure 5 décrit un premier exemple d'asservissement en fréquence, lequel pourra servir pour sélectionner la bande de réception WCDMA comme on le décrira ci-après. A cet effet, on intègre le composant résonateur BAW 320 dans une boucle à verrouillage de phase, également désignée sous l'appellation anglosaxonne de *Phase Locked Loop* (PLL).

A cet effet, le circuit ou bloc 320 comporte un comparateur de phase 510 ayant une première entrée 500 recevant une fréquence de référence qui sera la plus stable possible. Le comparateur de phase 510 dispose d'une seconde entrée recevant la sortie d'un élément diviseur 540.

En sortie, le comparateur de phase attaque un filtre passe-bas 520, lequel génère en sortie un potentiel $V_{tune}$ qui est utilisé pour commander un composant CRR 530 disposé dans le bloc Maître. Le même potentiel est utilisé comme signal de commande pour le composant CRR dual (non représenté sur la figure 5) qui est situé dans le bloc esclave et qui sert à réaliser le filtre linéaire souhaité.

Le composant CRR 530 est intégré dans un système oscillant dont tous les éléments sont appariés aux éléments du bloc esclave. Le système oscillant du bloc Maître génère en sortie une fréquence qui est transmise au bloc diviseur 540 assurant une division par un nombre N supérieur ou égal à 1, fixe ou variable, entier ou fractionnaire.

On obtient ainsi, grâce à ce schéma de régulation un asservissement de la fréquence généré par le circuit oscillant sur un multiple de N fois la fréquence d'entrée du bloc Maître.

Cet asservissement est reproduit dans le composant CRR dual situé dans le bloc esclave 310 de manière à venir précisément fixer le point de fonctionnement du circuit 310 l'incorporant et, par conséquent, de venir régler les paramètres du filtre linéaire réalisé par le bloc 310, notamment la fréquence centrale.

L'homme du métier pourra adapter l'enseignement de l'invention à la réalisation d'un autre type d'asservissement en fréquence, et notamment de type *Frequency Locked Loop* (FLL).

Plus généralement, on pourra considérer de multiples autres variantes d'asservissement, et notamment une boucle d'asservissement de type ALL.

### B. Boucle d'asservissement de type ALL

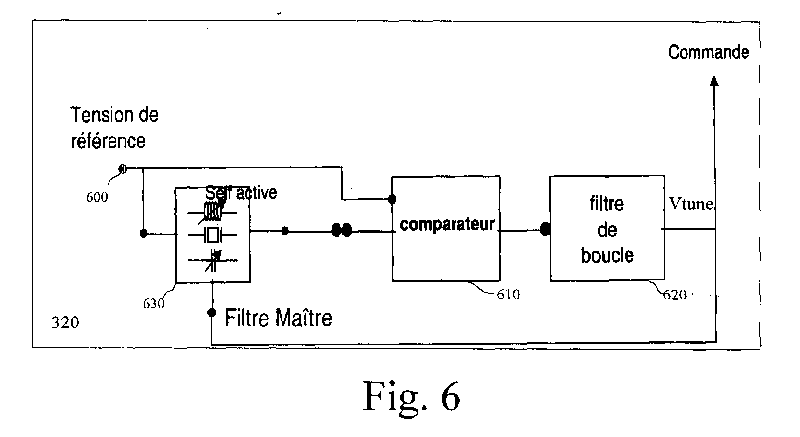

La figure 6 illustre un second exemple du bloc Maître 320 dans lequel on réalise avantageusement un circuit d'asservissement en amplitude , de type ALL ou *Amplitude Locked Loop* suivant la terminologie anglosaxonne.

A cet effet, le circuit comporte un comparateur de tension 610 ayant une première entrée 600 recevant un potentiel de référence qui sera le plus stable possible. Le comparateur 610 dispose d'une seconde entrée recevant un potentiel résultant du fonctionnement d'un circuit à réponse de phase linéaire, de type filtre, utilisant un composant CRR réglable doté de ses deux éléments compagnons, tel que décrit précédemment.

Le comparateur 610 fournit en sortie une erreur qui est filtrée par un filtre de boucle 620 - généralement un filtre passe-bas - lequel génère un potentiel de commande $V_{tune}$ qui est transmis aux électrodes de commande des deux CRR appariés, situés respectivement dans le bloc Esclave 310 et dans le bloc Maître 320.

Comme on l'a décrit précédemment, le potentiel de commande $V_{tune}$ pourra servir à commander un varactor, une inductance active etc.... , afin de venir précisément régler le point de fonctionnement du composant résonateur réglable dans le bloc Maître 320.

On peut ainsi asservir indirectement le point de fonctionnement du ou des composants résonateurs réglables qui sont situés dans le bloc Esclave 310.

### C. Asservissement du facteur de qualité du composant résonateur et de sa fréquence centrale

Les deux boucles d'asservissement - en fréquence et en tension - que l'on vient de décrire ne sont pas forcément exclusives l'une de l'autre. On décrit à présent comment on peut avantageusement les combiner pour réaliser un asservissement extrêmement sophistiqué et des plus avantageux.

Dans ce troisième exemple d'asservissement, le circuit maître comporte à présent, simultanément, une première boucle à verrouillage de phase (PLL), telle que décrite précédemment, associée ou combinée à une boucle de type ALL permettant d'asservir le facteur de qualité dudit circuit CRR.

A cet effet on dispose un premier bloc Maître 710 comportant au moins un premier CRR réglable 711 semblable aux précédent et recevant à une entrée 712 une fréquence de référence particulièrement stable. Le premier bloc est typiquement un asservissement en fréquence réalisé au moyen d'une boucle à verrouillage de phase telle que décrite précédemment, basée sur une fréquence de résonance .

Cet premier bloc Maître génère une première grandeur électrique de commande, vtune1 qui est transmise à un composant résonateur réglable CRR 703 localisé dans un bloc Esclave 700. Comme précédemment, le bloc Esclave 700 pourra servir à réaliser toute fonction de filtrage linéaire, voire tout circuit électrique quelconque.

On dispose également un second bloc Maître 720 qui comporte un second composant résonateur réglable 721 semblable au précédent et recevant à une entrée 722 une tension de référence particulièrement stable. Le second bloc 720 est utilisé pour réaliser un asservissement du facteur de qualité du composant résonateur réglable 721 de manière à venir ajuster, par effet miroir, le coefficient de qualité du résonateur Esclave 703 au moyen d'une seconde grandeur électrique $V_{tune2}$.

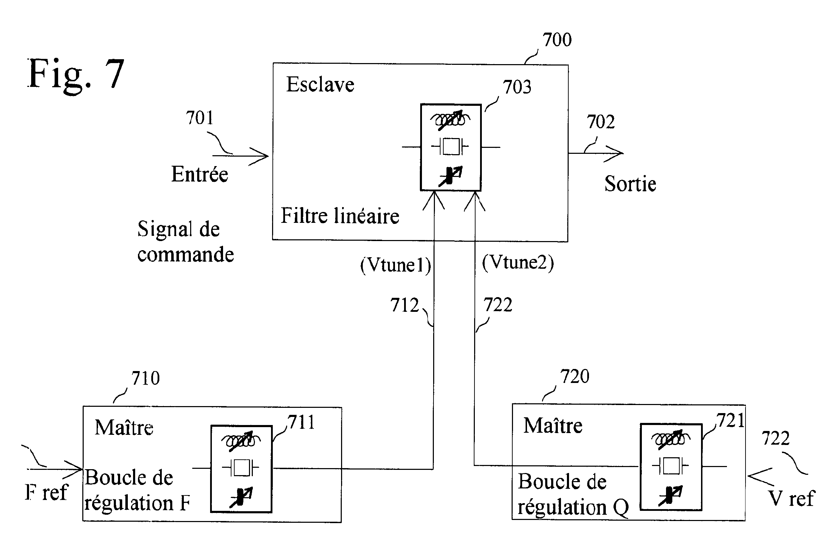

Comme on le voit sur la figure 7, le composant résonateur réglable 703 qui est disposé dans le bloc esclave 700 voit arriver deux grandeurs électriques de commandes, $V_{tune1}$ et $V_{tune2}$ que l'on pourra combiner avantageusement pour venir commander les paramètres des deux éléments compagnons inductifs et capacitifs.

A cet effet, on pourra envisager plusieurs modes de réalisation.

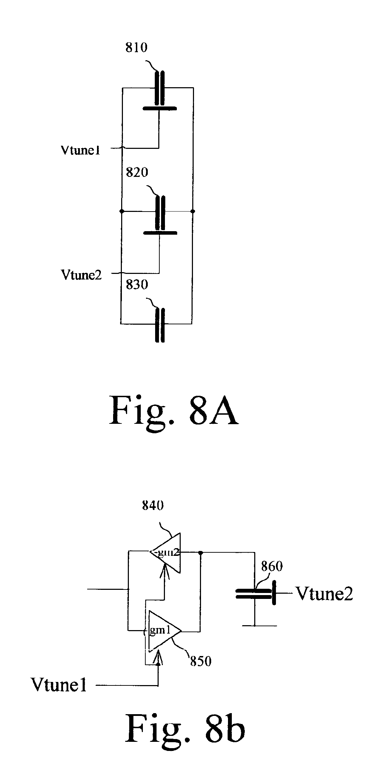

Dans un premier mode, tel que représenté dans la figure 8A, les deux grandeurs électriques de commande $V_{tune1}$ et $V_{tune2}$ sont utilisées pour commander respectivement deux varactors qui sont disposés dans une échelle de capacité/varactors montée en parallèle.

Ainsi, l'on peut réaliser un double asservissement, aussi bien en fréquence qu'au niveau du coefficient de qualité, du résonateur réglable 703.

Alternativement, les deux potentiels $V_{tune1}$ et $V_{tune2}$ servent à commander une inductance active composée d'un varactor et d'un gyrateur dont les deux éléments sont respectivement commandés par les grandeurs électriques Vtune1 et Vtune2.

Cet asservissement en coefficient de qualité et en fréquence sont particulièrement utiles pour maintenir les performances du résonateur BAW 703 et les rendre insensibles au procédé de fabrication ainsi qu'à la température.

### IV. Architecture hétérodyne intégrable

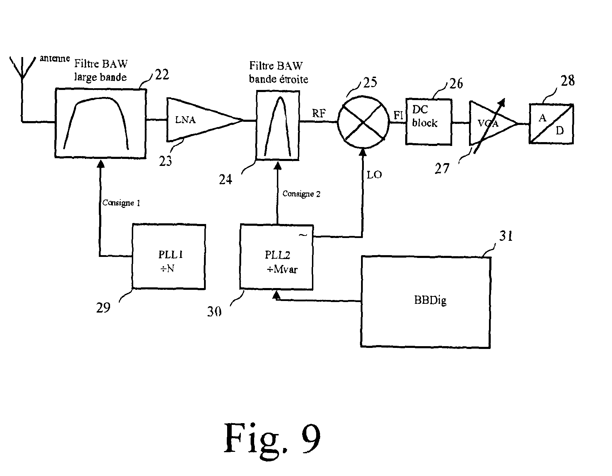

En référence à la figure 9, on décrit à présent comment les éléments qui viennent d'être décrits précédemment peuvent être combinées de manière à réaliser un circuit récepteur présentant une architecture de type hétérodyne particulièrement performante et, de surcroît, parfaitement intégrable.

Le circuit comporte une antenne large bande 21 conventionnelle, mais adaptée à la fréquence du signal à recevoir.

En aval de l'antenne, le circuit comporte un premier filtre passe-bande (22) destiné à recevoir le signal d'antenne, suivi d'un amplificateur à faible bruit 23 (*Low Noise Amplifier)* et ensuite un second filtre à bande étroite 24 destiné à supprimer la fréquence image et à sélectionner un canal particulier au sein de la bande de fréquence filtrée par le premier filtre 22.

Les deux filtres sont réalisés au moyen de résonateurs de type BAW, basés sur des Composants Résonateurs Réglables (CRR) tels que décrits précédemment, qui sont intégrables et réglables tous les deux, respectivement au moyen d'une première grandeur électrique (consigne1, $V_{tune}$ dans la figure 5) et d'une seconde grandeur électrique (consigne2, $V_{tune}$) générées par deux boucles d'asservissement de fréquence de type PLL.

La première boucle d'asservissement présent - et cela est représenté par le bloc 29 de la figure 9 - un facteur de division fixe, tandis que la seconde boucle d'asservissement de fréquence présente un facteur de division variable comme on le voit avec l'élément 30 de la figure 9.

En faisant varier le facteur de division de la seconde boucle d'asservissement, on peut venir régler le canal que l'on doit extraire de la bande de fréquence considérée.

Un circuit mélangeur 25 permettant de générer la fréquence intermédiaire (FI) à partir de la fréquence RF en aval du second filtre et d'une fréquence d'oscillation locale, en sorte que l'on peut ensuite effectuer un traitement du signal sur cette fréquence intermédiaire, à une valeur bien inférieure de celle du signal RF. La fréquence d'oscillation locale est aussi générée par la seconde boucle d'asservissement et correspond donc également à la bande de fréquence considérée.

A cet effet, le circuit comporte un bloc 26 destiné à supprimer la composante continue, puis un nouvel amplificateur 27 à gain variable (Variable Gain Amplifier) et, enfin, un convertisseur analogique numérique 28.

De préférence on construit les deux filtres 22 et 24 suivant une architecture maître/esclave telle que décrite dans la figure 3c.

Pour le premier filtre passe bande 22, on utilise un circuit esclave destiné à réaliser la fonction de transfert du premier filtre et un circuit maître destiné à être intégré dans la première boucle d'asservissement de fréquence.

Plus spécialement, et en se référant à la figure 3c, le circuit esclave comporte au moins un premier résonateur BAW 311 dotée d'une fréquence de résonance et d'une fréquence d'antirésonance et associé à ses deux éléments compagnons, inductif et capacitif. L'un au moins des deux éléments compagnons étant réglable au moyen de ladite première grandeur électrique (consigne 1, $V_{tune}$).

Le circuit maître du premier filtre comporte au moins un second résonateur BAW disposé sur le même substrat que le précédent et associé à ses deux éléments compagnons, inductif et capacitif. L'un au moins des deux éléments compagnons est réglable au moyen de ladite première grandeur électrique (consigne1, $V_{tune}$) générée par la première boucle d'asservissement de fréquence de type PLL.

Comme on l'a vu précédemment, la commande des caractéristiques des résonateurs peut être effectuée de diverses manières. De préférence, l'élément capacitif - associé par exemple au premier résonateur BAW - un varactor commandé par ladite première grandeur électrique (consigne1, $V_{tune}$). De préférence, l'élément inductif est composé d'une inductance spirale disposé sur le substrat de silicium dudit résonateur. Alternativement, l'élément inductif associé au premier ou au second résonateur est composé d'un gyrateur comportant deux amplificateurs à transconductance et une capacité, ladite première grandeur électrique (consigne1, $V_{tune}$) venant fixer le point de polarisation desdits amplificateurs. Dans un autre mode de réalisation , l'élément inductif associé à un résonateur est composé d'un gyrateur comportant deux amplificateurs à transconductance et un varactor, ladite première grandeur électrique (consigne1, $V_{tune}$) venant régler la valeur de la capacité dudit varactor.

D'une manière similaire, le second filtre 24 à bande étroite est réalisé au moyen d'un circuit maître/esclave comportant un circuit esclave destiné à réaliser la fonction de transfert bande étroite du second filtre et un circuit maître destiné à être intégré dans la seconde boucle d'asservissement.

Le circuit esclave du second filtre comporte au moins un premier résonateur BAW associé à ses deux éléments compagnons, respectivement inductif et capacité. L'un des éléments est réglable au moyen de ladite seconde grandeur électrique (consigne2, $V_{tune}$).

Le circuit maître du second filtre comporte au moins un second résonateur BAW disposé sur le même substrat que le précédent, et associé à ses deux composants compagnons, respectivement inductif et capacitif. L'un au moins des deux éléments compagnons est réglable au moyen de ladite seconde grandeur électrique (consigne2, $V_{tune}$) et intégré dans ladite seconde boucle d'asservissement de fréquence, laquelle comporte un facteur de division réglable permettant de sélectionner un canal désiré.

Comme pour le premier filtre, on pourra venir agir et régler de diverses manière les résonateurs du circuit maître/esclave du second filtre.

Ainsi, le premier filtre 22 basé sur un CRR est destiné à sélectionner toute la bande de 60 Mhz allouée à la norme WCDMA. Comme on peut le constater avec le bloc 29 de division par N de la figure 9, le rang de la division de la première boucle d'asservissement de fréquence de type PLL est fixe dans un mode de réalisation préféré. L'oscillateur commandé en tension (VCO1) (non représenté sur la figure 9 à des fins de clarté mais correspondant à l'élément oscillant 530 de la figure 5 construit à partir d'un CRR) oscille autour d'une fréquence égale au centre de la bande passante allouée à la communication CDMA descendante (par ex, pour la norme W-CDMA, $f_{osc}$ = 2140MHz). Il comprend des résonateurs BAW, de capacités fixes ou variables (type varicap) et/ou d'inductances type bobine ou inductance active (réalisées avec des composants actifs). Tous ces éléments sont appareillés à ceux réalisant le filtre 22. La consigne générée par cette première boucle d'asservissement sert à commander les éléments variables du CRR, à savoir soit des capacités variables, soit des selfs actives variables comme cela est décrit dans les figures 4a-4c et 8a-8b.

Cette première boucle d'asservissement permet de fixer le gabarit du filtre 22 et d'en asservir les caractéristiques, malgré la dispersion résultant du procédé de fabrication et les variations de température.

De préférence, le filtre 22 est associé à un asservissement du facteur de qualité, tel que décrit précédemment en relation avec la figure 7. On peut ainsi réaliser de manière très avantageuse un filtre de bande de 60 Mhz (dans le mode de réalisation préféré) qui présente des flancs très raides grâce au fort coefficient de qualité du résonateur BAW.

Le circuit de la figure 9 comporte ensuite, en aval du filtre 22, un amplificateur à faible bruit 23, suivi du second filtre 24 basé, lui également, sur une architecture maître/esclave, avec le circuit esclave réalisant la fonction de transfert du filtre à bande étroite et le circuit maître étant intégré dans la seconde boucle d'asservissement de fréquence, doté d'un facteur de division réglable. Il en résulte un filtre très performant, capable de sélectionner un seul canal de communication de 5 Mhz au sein de la bande de 60 Mhz , et également capable de supprimer la fréquence image. On note que, en pratique, le filtre 24 à bande étroite présente des flancs moins raides que ceux du précédent filtre 22.

Le facteur de division variable (Mvar) est supérieur à 1 et varie par pas de 1 dans la gamme : N-2%...N+2% commandé par un bloc BBDig 31 - regroupant tout la partie bande de base numérique du traitement du signal. L'oscillateur commandé en tension (VCO2) (non représenté dans la figure 9 mais correspondant à l'élément oscillant 530 de la figure 5) oscille autour d'une fréquence égale au centre de la bande passante allouée à la communication CDMA descendante (par ex, pour la norme W-CDMA, $f_{osc}$ = 2140MHz). Il est basé sur un CRR comportant des résonateurs BAW, de capacités fixes ou variables (type varicap) et/ou d'inductances type bobine ou inductance active (réalisées avec des composants actifs). Tous ces éléments sont appareillés à ceux constituant le filtre à bande étroite 24.

On peut ainsi, de manière très efficace, choisir un des canaux de 5Mhz au sein de toute la bande de 60Mhz allouée à la communication WCDMA.

On réalise ainsi, en une seule étape, un asservissement de type PLL permettant de fixer le canal de réception et de compenser les variations en températures et celles liées au procédé de fabrication.

D'une manière générale, le choix du canal est réalisé au moyen d'un bloc diviseur variable 30 commandé par un bloc numérique 31 en fonction des informations de signalisation échangées entre le mobile et la station de base. Comme on le sait, en effet, une fois établie la communication entre la station de base et le terminal mobile, le canal à utiliser est parfaitement déterminé et il en résulte le choix d'un facteur de division par le bloc 30 sous la commande du bloc 31.

Ainsi, dans l'invention, le rapport de division du bloc 30 associé au circuit d'asservissement du second filtre est fixé en fonction de la procédure de signalisation entre la station de base et le terminal mobile.

De préférence, le bloc 30 fournit également - et cela de manière particulièrement avantageuse - la fréquence LO de l'oscillateur local qui est transmise à un mélangeur 25 recevant également le signal RF filtré par le second filtre 24.

Ainsi, la commande du bloc 30 permet de réaliser, en une seule étape, la détermination du choix du canal mais aussi la fixation de la fréquence de l'oscillateur local qui est utilisé par le mélangeur 25.

En outre, la consigne de cette boucle sert à piloter des éléments variables du filtre BAW à bande étroite 24 (soit des capacités variables, soit des selfs actives variable) et le signal a la sortie du VCO sert à délivrer le signal 'Oscillateur Local' au mélangeur de fréquences. Les contraintes de bruit de phase sont celles spécifiques aux récepteurs 'classiques' pour les normes CDMA.

En sortie du mélangeur 25, la fréquence intermédiaire FI est transmise à un bloc 26 dit « DC block » destiné à la suppression de la composante continue.

Le circuit de la figure 9 comporte ensuite un amplificateur à gain variable 27 (dit *Variable Gain Amplifier*), suivi d'un convertisseur analogique numérique 28 permettant de transformer en un format numérique le signal de réception traité.

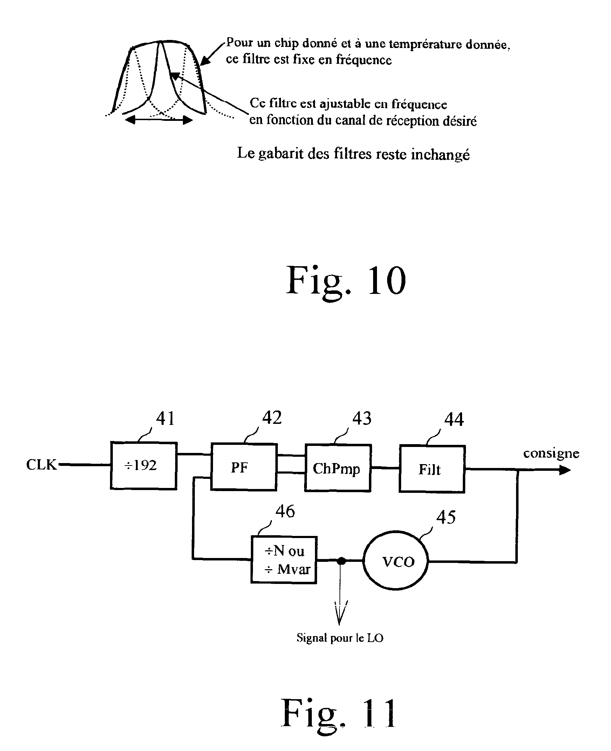

Le fonctionnement de cette architecture est illustré dans la figure 10. Comme on le voit, Le filtre large bande 22 atténue jusqu'à un niveau acceptable tous les blockers hors-bande à des fréquences fixes (d'où l'intérêt de prévoir une fonction de transfert présentant des flancs raides). Le filtre à bande étroite 24 sélectionne seulement le canal désiré. Toute fréquence image est ainsi facilement éliminée. La consigne qui commande ce filtre est également la consigne de la boucle PLL qui fournit le signal d'Oscillateur Local. Le canal désiré est ainsi uniquement défini.

Comme on le constate, le circuit de la figure 9 permet de réaliser, au moyen de composants acoustiques BAW qu'il est possible d'intégrer dans un même produit semi-conducteur, une architecture complète de récepteur numérique particulièrement performante, du fait du fort coefficient de qualité offert par les résonateurs de type BAW et la grande capacité de régulation permise par les différentes boucles d'asservissement qui ont été décrites.

D'une manière générale, ces performances sont atteintes grâce à la qualité des divers asservissements qu'il est possible de réaliser du fait de la grande flexibilité du composant CRR que l'on a décrit.

Un circuit récepteur - basé sur une architecture hétérodyne - devient ainsi complètement intégrable.

On note en outre que l'architecture hétérodyne qui est proposée n'emploie qu'un seul mélangeur, contrairement aux techniques connues qui, en général, font appel à deux mélangeurs utilisés successivement.
Les valeurs indiquées ci-après ne sont données qu'à titre d'exemple illustratif.
Pour les récepteur W-CDMA, la fréquence de l'horloge système est souvent choisie comme CLK = 38.4 MHz. Dans la norme W-CDMA, les canaux ont une largeur de 5MHz, mais le pas de l'Oscillateur Local doit être de 200kHz.

La figure 11 illustre un exemple de réalisation concrète des deux boucles d'asservissements en fréquence, respectivement PLL1 et PLL2, typiquement adaptées à la réalisation d'un récepteur W-CDMA :

- un bloc diviseur 41
- un comparateur de phase 42
- une pompe de charge 43
- un filtre 44
- un VCO 45 réalisé au moyen d'un Composant Résonateur Réglable
- un bloc diviseur 46

Le signal qui attaque les PLL est ainsi à 200kHz, on choisit N = 10700 et Mvar = 10550 ... 10850 par pas de 1, soit 1.4% de variation autour de la valeur de N. La consigne de PLL1 délivre ainsi un signal tel que la fréquence du VCO est 2140MHz, tandis que la consigne de PLL2 délivre un signal tel que la fréquence du VCO varie de 2110 à 2170MHz, par pas de 200kHz.
Cette architecture présente notamment les avantages suivants :

☐ Ce système permet de réaliser un récepteur de type <u>hétérodyne</u> en un seul composant électrique (forte intégration).
☐ La sélection de canal se fait de façon unique, avec une bonne qualité de réjection de la fréquence image.
☐ Le plan de fréquence du récepteur peut être simplifié, une seule fréquence intermédiaire est nécessaire, qui doit être supérieure à $B_{p\_canal}/2$.
☐ L'injection du signal LO vers l'antenne est réduite.
☐ Les offsets DC sont éliminés relativement facilement par le 'DC block'.
☐ Le filtrage de bande de base n'est plus nécessaire, ou alors demande des contraintes très relaxées.
☐ La partie de bande de base (après le mélangeur) ne présente pas deux voies en quadrature, ce qui implique :

    i. pas de contraintes d'appariement entre les deux voies ;
    ii. architecture simplifiée pour le mélangeur de fréquences ;
    iii. consommation réduite de cette partie ;
    iv. architecture simplifiée pour le convertisseur analogique-numérique.

☐ Les blocs de synthèse de fréquence opèrent à des fréquences voisines de la fréquence RF du signal utile (ex pour W-CDMA, 2000MHz), et non pas le double de la fréquence incidente (comme c'est le cas dans les récepteurs dits **'IQ'**).

**Revendications**

1. Circuit de réception hétérodyne pour un système de communication numérique comportant :

   - un premier filtre passe-bande (22) destiné à recevoir un signal d'une antenne (21), ledit premier filtre comportant au moins un premier composant résonateur de type BAW réglable au moyen d'un première grandeur électrique (consigne1, $V_{tune}$), ladite première grandeur électrique étant générée par une première boucle d'asservissement de fréquence de type PLL;
   - un amplificateur disposé en aval dudit premier filtre ;
   - un second filtre à bande étroite (24) placé en aval dudit amplificateur et dudit premier filtre passe-bande (22) et recevant une bande de fréquence filtrée par ledit premier filtre (22), ledit second filtre (24) comportant au moins un second composant résonateur de type BAW réglable au moyen d'une seconde grandeur électrique (consigne2, $V_{tune}$), ladite seconde grandeur électrique étant générée par une seconde boucle d'asservissement de fréquence de type PLL présentant un facteur de division variable afin de permettre la sélection d'un canal particulier au sein de ladite bande de fréquence ;
   - un mélangeur destiné à mélanger le signal en sortie dudit second filtre (24) et une fréquence d'oscillation locale afin de générer une fréquence intermédiaire ;
   - un système de traitement numérique de ladite fréquence intermédiaire.

2. Circuit de réception hétérodyne selon la revendication 1 **caractérisé en ce que** ledit premier filtre passe bande (22) est réalisé au moyen d'un circuit maître/esclave comportant :

   - un circuit esclave destiné à réaliser la fonction de transfert dudit premier filtre, ledit circuit esclave comportant au moins un premier résonateur BAW (311) ayant une fréquence de résonance et une fréquence d'antirésonance, ledit au moins premier résonateur BAW étant associé à un premier élément compagnon de type inductif calé dans un voisinage desdites fréquence de résonance et d'antirésonance ; et à un second élément compagnon de type capacitif , l'un au moins des deux éléments compagnons étant réglable au moyen de ladite première grandeur électrique (consigne 1, $V_{tune}$),
   - un circuit maître ayant au moins un second résonateur BAW (321) disposé sur le même substrat que ledit premier résonateur BAW (311) et ayant une fréquence de résonance et une fréquence d'antirésonance, ledit au moins second résonateur BAW (321) étant associé à un premier élément compagnon de type inductif calé dans un voisinage desdites fréquence de résonance et d'antirésonance ; et à un second élément compagnon de type capacitif , l'un au moins des deux éléments compagnons étant réglable au moyen de ladite première grandeur électrique (consigne1, $V_{tune}$).

ledit second résonateur BAW étant intégré dans la première boucle d'asservissement de fréquence de type PLL de manière à générer ladite première grandeur électrique (consigne1, $V_{tune}$) venant fixer les caractéristiques dudit premier filtre (22).

3. Circuit de réception hétérodyne selon la revendication 2 **caractérisé en ce que** ledit élément capacitif est un varactor commandé par ladite première grandeur électrique (consigne1, $V_{tune}$).

4. Circuit de réception hétérodyne selon la revendication 2 **caractérisé en ce que** ledit élément inductif est composé d'une inductance spirale disposé sur le substrat de silicium desdits premier et second résonateurs.

5. Circuit de réception hétérodyne selon la revendication 2 **caractérisé en ce que** ledit élément inductif associé au résonateur est composé d'un gyrateur comportant deux amplificateurs à transconductance et une capacité, ladite première grandeur électrique (consigne1, $V_{tune}$) venant fixer le point de polarisation desdits amplificateurs.

6. Circuit de réception hétérodyne selon la revendication 2 **caractérisé en ce que** ledit élément inductif associé au résonateur est composé d'un gyrateur comportant deux amplificateurs à transconductance et un varactor, ladite première grandeur électrique (consigne1, $V_{tune}$) venant régler la valeur de la capacité dudit varactor.

7. Circuit de réception hétérodyne selon la revendication 1 **caractérisé en ce que** le second filtre est réalisé au moyen d'un circuit maître/esclave comportant :

 - un circuit esclave destiné à réaliser la fonction de transfert dudit second filtre et comportant au moins un premier résonateur BAW (311) ayant une fréquence de résonance et une fréquence d'antirésonance, ledit au moins premier résonateur BAW (311) étant associé à un premier élément compagnon de type inductif calé dans un voisinage des fréquences dites de résonance et d'antirésonance et à un second élément compagnon de type capacitif, ledit au moins premier résonateur BAW étant réglable au moyen de ladite seconde grandeur électrique (consigne2, $V_{tune}$) ;
 - un circuit maître ayant au moins un second résonateur BAW (321) disposé sur ledit substrat et ayant une fréquence de résonance et une fréquence d'antirésonance, ledit au moins second résonateur BAW étant associé à un premier élément compagnon de type inductif calé dans un voisinage desdites fréquence résonance et d'antirésonance ; et à un second élément compagnon de type capacitif , l'un au moins des deux éléments compagnons étant réglable au moyen de ladite seconde grandeur électrique (consigne2, $V_{tune}$) et intégré dans ladite seconde boucle d'asservissement de fréquence ;

8. Circuit de réception hétérodyne selon la revendication 7 **caractérisé en ce que** ledit élément capacitif associé au résonateur est un varactor commandé par ladite grandeur électrique ($V_{tune}$).

9. Circuit de réception hétérodyne selon la revendication 7 **caractérisé en ce que** ledit élément inductif associé au résonateur est composé d'une inductance spirale disposé sur le substrat de silicium desdits premiers et second résonateurs.

10. Circuit de réception hétérodyne selon la revendication 7 **caractérisé en ce que** ledit élément inductif associé au résonateur est composé d'un gyrateur comportant deux amplificateurs à transconductance et une capacité, ladite seconde grandeur électrique (consigne2, $V_{tune}$) venant fixer le point de polarisation desdits amplificateurs .

11. Circuit de réception hétérodyne selon la revendication 7 **caractérisé en ce que** ledit élément inductif associé au résonateur est composé d'un gyrateur comportant deux amplificateurs à transconductance et un varactor, ladite seconde grandeur électrique (consigne 2, $V_{tune}$) venant régler la valeur de la capacité dudit varactor.

12. Circuit de réception hétérodyne selon la revendication 12 **caractérisé en ce que** , la seconde boucle d'asservissement sert également à générer la fréquence d'oscillation locale transmise au mélangeur.

**Fig. 1**

## Fig. 2a

## Fig. 2b

## Fig. 2c

Fig. 3A

Fig. 3B

Fig. 3c

Fig. 4a

Vtune

400

Fig. 4b

451

-gm2

453

gm1

452

Vtune

≡

Fig. 4c

461

-gm2

460

gm1

462

464

gm1

453

469

-gm2

465

Vtune

≡

460

469

Régulation de f0

Système oscillant appareillé
aux éléments du filtre

500

Comparateur de phase      Filtre passe-bas

Fréquence
de référence

$\Delta\Phi$

510

520

Vtuned

Maître

530

+N (var ou fixe), ≥1

320

540

Fig. 5

EP 1 601 110 A1

Fig. 6

# Fig. 7

700

**Esclave** 703

701

Entrée

Signal de commande

Filtre linéaire

702

Sortie

(Vtune1) (Vtune2)

712 722

710

**Maître** 711

F ref

Boucle de régulation F

720

**Maître** 721

722

Boucle de régulation Q

V ref

EP 1 601 110 A1

810

820

Vtune1

Vtune2

830

# Fig. 8A

840

gm2

860

Vtune2

gm1

850

Vtune1

# Fig. 8b

Fig. 9

Pour un chip donné et à une temprérature donnée, ce filtre est fixe en fréquence

Ce filtre est ajustable en fréquence en fonction du canal de réception désiré

Le gabarit des filtres reste inchangé

# Fig. 10

CLK — [41 ÷192] — [42 PF] — [43 ChPmp] — [44 Filt] — consigne

[46 ÷N ou ÷ Mvar] — [45 VCO]

Signal pour le LO

# Fig. 11

**Office européen**
**des brevets**

**RAPPORT DE RECHERCHE EUROPEENNE**

Numéro de la demande

EP 05 39 2003

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 6 112 070 A (KATSUYAMA TSUTOMU ET AL) 29 août 2000 (2000-08-29) <br> * figures 1,3 * <br> * colonne 4, ligne 57 - colonne 5, ligne 2 * <br> * colonne 5, ligne 32 - ligne 44 * <br> * colonne 7, ligne 28 - ligne 36 * <br> ----- | 1-12 | H04B1/26 <br> H04B1/10 <br> H03H7/01 |
| X | US 5 963 856 A (KIM H H) 5 octobre 1999 (1999-10-05) <br> * revendications 1,3,6; figures 2a,3 * <br> * colonne 4, ligne 19 - ligne 26 * <br> * colonne 5, ligne 30 - ligne 41 * <br> * colonne 6, ligne 4 - ligne 11 * <br> ----- | 1-12 | |
| A | US 6 542 724 B1 (MARCHESAN DAVID ET AL) 1 avril 2003 (2003-04-01) <br> * figures 1,2 * <br> * colonne 4, ligne 16 - ligne 35 * <br> ----- | 2,7 | |

DOMAINES TECHNIQUES RECHERCHES (Int.Cl.7)

H04B
H03D
H03H

Le présent rapport a été établi pour toutes les revendications

| Lieu de la recherche | Date d'achèvement de la recherche | Examinateur |
|---|---|---|
| Berlin | 5 octobre 2005 | Fouasnon, O |

**ANNEXE AU RAPPORT DE RECHERCHE EUROPEENNE
RELATIF A LA DEMANDE DE BREVET EUROPEEN NO.**

EP 05 39 2003

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-10-2005

| Document brevet cité au rapport de recherche | Date de publication | Membre(s) de la famille de brevet(s) | Date de publication |
|---|---|---|---|
| US 6112070       A | 29-08-2000 | JP      9289467 A | 04-11-1997 |
| US 5963856       A | 05-10-1999 | AUCUN | |
| US 6542724       B1 | 01-04-2003 | AUCUN | |

EPO FORM P0460